# EUROPÄISCHE PATENTSCHRIFT

(11) **EP 3 097 595 B1**
(45) Veröffentlichungstag und Bekanntmachung des Hinweises auf die Patenterteilung: **27.05.2020**
(21) Anmeldenummer: 15701165.1
(22) Anmeldetag: 20.01.2015
(51) Int. Cl.: H01L 51/52

(54) **UV-GESCHÜTZTES BAUELEMENT FÜR OLEDS**
UV-PROTECTED COMPONENT FOR OLEDS
DISPOSITIF PROTEGÉ CONTRE LE RAYONNEMENT UV POUR OLEDS

(30) Priorität: 21.01.2014 EP 14152023; 02.10.2014 EP 14187500
(43) Veröffentlichungstag der Anmeldung: 30.11.2016
(73) Patentinhaber: Covestro Deutschland AG, 51373 Leverkusen (DE); OSRAM OLED GMBH, 93049 Regensburg (DE)
(72) Erfinder: PUDLEINER, Heinz, 47800 Krefeld (DE); MEYER, Klaus, 41539 Dormagen (DE); KRUMMACHER, Benjamin, 93059 Regensburg (DE); SCHICKTANZ, Simon, 93049 Regensburg (DE)
(74) Vertreter: Levpat
(86) Internationale Anmeldenummer: PCT/EP2015/051002
(87) Internationale Veröffentlichungsnummer: WO 2015/110426

(56) Entgegenhaltungen:
- DE-A1-102006 059 129
- DE-A1-102009 025 123
- GB-A- 2 333 897
- US-A1- 2012 227 809
- Anonymous: "Polymethacrylat", , 31 December 2012 (2012-12-31), XP055447778, Retrieved from the Internet: URL:http://universal_lexikon.deacademic.co m/147489/Polymethacrylat [retrieved on 2018-02-05]

## Beschreibung

Die vorliegende Erfindung betrifft ein organisches strahlungsemittierendes Bauelement mit einer zur Strahlungserzeugung ausgebildeten aktiven organischen Schicht und einer oder zwei Strahlungsauskoppelseiten. Des Weiteren betrifft die Erfindung die Verwendung des erfindungsgemäßen Bauelements als organische lichtemittierende Diode, sowie zur Beleuchtung, insbesondere zur Allgemeinbeleuchtung.

Ultraviolette Strahlung kann insbesondere bei OLEDs die organische, zur Strahlungserzeugung vorgesehene Schicht schädigen und einen Defekt des Bauelements beschleunigt herbeiführen.

Die WO2005/083813 beschreibt beispielsweise OLEDs, die ein UV-Schutz Element aufweisen, das anorganische UV Absorber enthält. Werden jedoch Polymere als Matrixmaterial eingesetzt, so führt der Einsatz derartiger anorganischer UV Absorber zu Eintrübungen, da diese nicht in der Polymermatrix löslich sind.

Aus der WO2010/086272 ist weiterhin eine transparente, witterungsbeständige Barrierefolie bekannt, die aus einer dünnen, anorganisch beschichteten Folie als Trägerschicht und einer weiteren transparenten Folie besteht. Diese Barrierefolie kann auch die Aufgabe übernehmen OLEDs vor UV Strahlung zu schützen. Als Trägerschicht werden Folien aus Polyolefinen oder Polyestern eingesetzt. Die weitere Folie basiert auf Polymethylmethacrylat (PMMA) oder PMMA-Polyolefin- Coextrudaten. Solche Folien sind jedoch nicht vollständig klar und transparent und zeigen eine leichte Trübung.

Des Weiteren werden in DE102006059129 und DE102009025123 OLEDs mit UV-Schutzschichten offenbart.

Die der vorliegenden Erfindung zu Grunde liegende Aufgabe war es daher, ein Bauelement zur Verfügung zu stellen, das eine besonders hohe Langlebigkeit der zur Strahlungserzeugung ausgebildeten organischen Schicht und gleichzeitig eine vollständig transparente, glatte, glänzende und dennoch kratzfeste Oberfläche aufweist.

Diese Aufgabe wird erfindungsgemäß gelöst durch ein organisches strahlungsemittierendes Bauelement gemäß Anspruch 1.

Überraschender Weise hat sich gezeigt, dass die erfindungsgemäßen Folien vollständig transparent und zur Herstellung von Bauelementen geeignet sind, die sich durch eine hohe Langlebigkeit der zur Strahlungserzeugung ausgebildeten organischen Schicht auszeichnen. Zusätzlich weisen die mit der erfindungsgemäßen Folie ausgestatteten Bauelemente eine glatte, glänzende und dennoch kratzfeste Oberfläche auf.

Das erfindungsgemäße Bauelement umfasst mindestens eine UV-Schutzfolie, enthaltend mindestens eine erste Schicht (A) und eine zweite Schicht (B).

Die erste Schicht (A) enthält 1 bis 7,5 Gew.-% eines UV-Absorbers. Der UV-Absorber ist bevorzugt ein organischer UV-Absorber und beispielsweise ausgewählt aus der Gruppe Benzotriazol-Derivate, Dimere Benzotriazol-Derivate, Triazin-Derivate, Dimere Triazin-Derivate, Diarylcyanoacrylate oder Gemische der vorstehend genannten Verbindungen. In einer bevorzugten Ausbildung der Erfindung ist der UV-Absorber ein Triazin-Derivat, besonders bevorzugt ein Triazin der allgemeinen Formel (I): 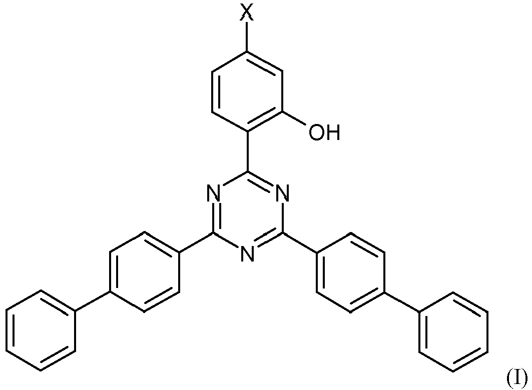 wobei X = OR¹; OCH₂CH₂OR¹; OCH₂CH(OH)CH₂OR¹ oder OCH(R²)COOR³ bedeutet, dabei kann R¹ für jeweils ein verzweigtes oder unverzweigtes C₁-C₁₃-Alkyl, C₂-C₂₀-Alkenyl, C₆-C₁₂-Aryl oder -CO-C₁-C₁₈-Alkyl, R² für H oder ein verzweigtes oder unverzweigtes C₁-C₈-Alkyl, und R³ C₁-C₁₂-Alkyl; C₂-C₁₂-Alkenyl oder C₅-C₆-Cycloalkyl stehen.

In einer besonders bevorzugten Ausbildung der erfindungsgemäßen weiteren Schicht, ist X = OR¹, wobei R¹ die oben genannte Bedeutung hat, ganz besonders bevorzugt ist X = OR¹, wobei R¹ = CH₂CH(CH₂CH₃)C₄H₉.

Solche biphenylsubstituierten Triazine der allgemeinen Formel I sind aus WO 96/28431; DE 197 39 797; WO 00/66675; US 6225384; US 6255483; EP 1 308 084 und FR 2812299 prinzipiell bekannt. Auch Gemische der vorstehend genannten Triazin-Derivate können eingesetzt werden. Da für einen dauerhaften UV-Schutz eine bestimmte Mindestextinktion der ersten Schicht benötigt wird, hängt die erforderliche UV-Absorber Konzentration auch von der Schichtdicke ab.

Die erste Schicht (A) weist eine Schichtdicke von ≥ 10 µm und ≤ 200 µm und bevorzugt ≥ 15 µm und ≤ 100 µm auf. In einer weiteren bevorzugten Ausgestaltung der Erfindung enthält die Schicht (A) einen für die in der aktiven Schicht erzeugte Strahlung durchlässigen Kunststoff, beispielsweise einen transparenten Thermoplasten.

Die erste Schicht (A) enthält einen transparenten Thermoplasten aus Polymethacrylat. Weitere, nicht erfindungsgemäße Beispiele für transparente Thermoplasten sind: Cycloolefin-Copolymere (COC; Topas® von der Fa. Ticona); Zenoex® von der Fa. Nippon Zeon oder Apel® von der Fa. Japan Synthetic Rubber, Polysulfone (Ultrason@ von der Fa. BASF oder Udel® von der Fa. Solvay), Polyester, wie z.B. PET oder PEN, Polycarbonat, Polycarbonat/Polyester-Blends, z.B. PC/PET, Polycarbonat/Polycyclohexylmethanolcyclohexandicarboxylat (PCCD; Xylecs® von der Fa. Sabic IP) und Polycarbonat/Polybutylenterephthalat (PBT) Blends.

In einer bevorzugten Ausführungsform der Erfindung enthält die ersten Schicht (A) ein Polyalkylmethacrylat mit Alkylkettenlängen unter 10 Kohlenstoffatomen (-CₙH₂ₙ₊₁ mit n < 10) und ganz besonders bevorzugt Polymethyl(meth)acrylat (PMMA, n = 1) oder ist daraus hergestellt.

Als Polyacrylat können sowohl Polymethyl(meth)acrylat (PMMA) als auch Blends aus PMMA oder aus schlagzähem PMMA eingesetzt werden. Sie sind unter der Marke Plexiglas® bei der Röhm GmbH erhältlich. Unter Polymethyl(meth)acrylat werden sowohl Polymere der Methacrylsäure und ihrer Derivate, beispielsweise ihrer Ester, als auch Polymere der Acrylsäure und ihrer Derivate als auch Mischungen aus beiden vorstehenden Komponenten verstanden. Bevorzugt sind Polymethyl(meth)acrylat-Kunststoffe mit einem Methylmethacrylat-Monomeranteil von mindestens 80 Gew.-%, bevorzugt mindestens 90 Gew.-% und gegebenenfalls 0 Gew.-% bis 20 Gew.-%, bevorzugt 0 Gew.-% bis 10 Gew.-% zweiter vinylisch copolymerisierbarer Monomere wie z. B. C₁- bis C₈-Alkylestern der Acrylsäure oder der Methacrylsäure, z. B. Methylacrylat, Ethylacrylat, Butylacrylat, Butylmethacrylat, Hexylmethacrylat, Cyclohexylmethacrylat, ferner Styrol und Styrolderivate, wie beispielsweise [alpha]-Methylstyrol oder p-Methylstyrol. Zweite Monomere können sein Acrylsäure, Methacrylsäure, Maleinsäureanhydrid, Hydroxyester der Acrylsäure oder Hydroxyester der Methacrylsäure.

Die ersten Schicht (A) enthält ein Polycarbonat oder ist daraus hergestellt. Geeignete Polycarbonate sind alle bekannten Polycarbonate. Dies können Homopolycarbonate, Copolycarbonate und thermoplastische Polyestercarbonate sein.

Sie haben bevorzugt mittlere Molekulargewichte M̅_{w} von 18.000 bis 40.000, vorzugsweise von 22.000 bis 36.000 und insbesondere von 24.000 bis 33.000, ermittelt durch Messung der relativen Lösungsviskosität in Dichlormethan oder in Mischungen gleicher Gewichtsmengen Phenol/o-Dichlorbenzol geeicht durch Lichtstreuung.

Zur Herstellung von Polycarbonaten sei beispielhaft auf "Schnell, Chemistry and Physics of Polycarbonats, Polymer Reviews, Vol. 9, Interscience Publishers, New York, London, Sydney 1964", und auf "D.C. PREVORSEK, B.T. DEBONA and Y. KESTEN, Corporate Research Center, Allied Chemical Corporation, Moristown, New Jersey 07960, 'Synthesis of Poly(ester)carbonate Copolymers' in Journal of Polymer Science, Polymer Chemistry Edition, Vol. 19, 75-90 (1980)", und auf "D. Freitag, U. Grigo, P.R. Müller, N. Nouvertne, BAYER AG, 'Polycarbonates' in Encyclopedia of Polymer Science and Engineering, Vol. 11, Second Edition, 1988, Seiten 648-718" und schließlich auf "Dres. U. Grigo, K. Kircher und P.R. Müller 'Polycarbonate' in Becker/Braun, Kunststoff-Handbuch, Band 3/1, Polycarbonate, Polyacetale, Polyester, Celluloseester, Carl Hanser Verlag München, Wien 1992, Seiten 117-299" verwiesen.

Die Herstellung der Polycarbonate erfolgt vorzugsweise nach dem Phasengrenzflächenverfahren oder dem Schmelze-Umesterungsverfahren und wird im Folgenden beispielhaft an dem Phasengrenzflächenverfahren beschrieben.

Als Ausgangsverbindungen bevorzugt einzusetzende Verbindungen sind Bisphenole der allgemeinen Formel

HO-R-OH,

worin R ein divalenter organischer Rest mit 6 bis 30 Kohlenstoffatomen ist, der eine oder mehrere aromatische Gruppen enthält.

Beispiele solcher Verbindungen sind Bisphenole, die zu der Gruppe der Dihydroxydiphenyle, Bis(hydroxyphenyl)alkane, Indanbisphenole, Bis(hydroxyphenyl)ether, Bis(hydroxyphenyl)-sulfone, Bis(hydroxyphenyl)ketone und α,α'-Bis(hydroxyphenyl)-diisopropylbenzole gehören.

Besonders bevorzugte Bisphenole, die zu den vorgenannten Verbindungsgruppen gehören, sind Bisphenol-A, Tetraalkylbisphenol-A, 4,4-(meta-Phenylendiisopropyl) diphenol (Bisphenol M), 4,4-(para-Phenylendiisopropyl) diphenol, 1,1-Bis-(4-hydroxyphenyl)-3,3,5-trimethylcyclohexan (BP-TMC) sowie gegebenenfalls deren Gemische.

Bevorzugt werden die erfindungsgemäß einzusetzenden Bisphenolverbindungen mit Kohlensäureverbindungen, insbesondere Phosgen, oder beim Schmelzeumesterungsprozess mit Diphenylcarbonat bzw. Dimethylcarbonat, umgesetzt.

Polyestercarbonate werden bevorzugt durch Umsetzung der bereits genannten Bisphenole, mindestens einer aromatischen Dicarbonsäure und gegebenenfalls Kohlensäureäquivalente erhalten. Geeignete aromatische Dicarbonsäuren sind beispielsweise Phthalsäure, Terephthalsäure, Isophthalsäure, 3,3'- oder 4,4'-Diphenyldicarbonsäure und Benzophenondicarbonsäuren. Ein Teil, bis zu 80 Mol.-%, vorzugsweise von 20 bis 50 Mol-% der Carbonatgruppen in den Polycarbonaten können durch aromatische Dicarbonsäureester-Gruppen ersetzt sein.

Beim Phasengrenzflächenverfahren verwendete inerte organische Lösungsmittel sind beispielsweise Dichlormethan, die verschiedenen Dichlorethane und Chlorpropanverbindungen, Tetrachlormethan, Trichlormethan, Chlorbenzol und Chlortoluol, vorzugsweise werden Chlorbenzol oder Dichlormethan bzw. Gemische aus Dichlormethan und Chlorbenzol eingesetzt.

Die Phasengrenzflächenreaktion kann durch Katalysatoren wie tertiäre Amine, insbesondere N-Alkylpiperidine oder Oniumsalze beschleunigt werden. Bevorzugt werden Tributylamin, Triethylamin und N-Ethylpiperidin verwendet. Im Falle des Schmelzeumesterungsprozesses werden bevorzugt die in DE-A 4 238 123 genannten Katalysatoren verwendet.

Die Polycarbonate können durch den Einsatz geringer Mengen Verzweiger bewusst und kontrolliert verzweigt werden. Einige geeignete Verzweiger sind: Phloroglucin, 4,6-Dimethyl-2,4,6-tri-(4-hydroxyphenyl)-hepten-2; 4,6-Dimethyl-2,4,6-tri-(4-hydroxyphenyl)-heptan; 1,3,5-Tri-(4-hydroxyphenyl)-benzol; 1,1,1 -Tri-(4-hydroxyphenyl)-ethan; Tri-(4-hydroxyphenyl)-phenylmethan; 2,2-Bis-[4,4-bis-(4-hydroxyphenyl)-cyclohexyl]-propan; 2,4-Bis-(4-hydroxyphenyl-isopropyl)-phenol; 2,6-Bis-(2-hydroxy-5'-methyl-benzyl)-4-methylphenol; 2-(4-Hydroxyphenyl)-2-(2,4-dihydroxyphenyl)-propan; Hexa-(4-(4-hydroxyphenyl-isopropyl)-phenyl)-orthoterephthalsäure-ester; Tetra-(4-hydroxyphenyl)-methan; Tetra-(4-(4-hydroxyphenyl-isopropyl)-phenoxy)-methan; α,α,'α"-Tris-(4-hydroxyphenyl)-1,3,5-triisopropylbenzol; 2,4-Dihydroxybenzoesäure; Trimesinsäure; Cyanurchlorid; 3,3-Bis-(3-methyl-4-hydroxyphenyl)-2-oxo-2,3-dihydroindol; 1,4-Bis-(4',4"-dihydroxytriphenyl)-methyl)-benzol und insbesondere: 1,1,1-Tri-(4-hydroxyphenyl)-ethan und Bis-(3-methyl-4-hydroxyphenyl)-2-oxo-2,3-dihydroindol.

Die gegebenenfalls mitzuverwendenden 0,05 bis 2 Mol-%, bezogen auf eingesetzte Diphenole, an Verzweigern bzw. Mischungen der Verzweigern, können mit den Diphenolen zusammen eingesetzt werden aber auch in einem späteren Stadium der Synthese zugegeben werden.

Als Kettenabbrecher werden bevorzugt Phenole wie Phenol, Alkylphenole wie Kresol und 4-tert.-Butylphenol, Chlorphenol, Bromphenol, Cumylphenol oder deren Mischungen verwendet in Mengen von 1 - 20 Mol-%, bevorzugt 2 - 10 Mol-% je Mol Bisphenol. Bevorzugt sind Phenol, 4-tert.-Butylphenol bzw. Cumylphenol.

Kettenabbrecher und Verzweiger können getrennt oder aber auch zusammen mit dem Bisphenol den Synthesen zugesetzt werden.

Die Herstellung der Polycarbonate nach dem Schmelzeumesterungsprozess ist in DE-A 4238 123 beispielhaft beschrieben.

Erfindungsgemäß bevorzugte Polycarbonate für die erfindungsgemäße zweite Schicht (B) sind das Homopolycarbonat auf Basis von Bisphenol A, das Homopolycarbonat auf Basis von 1,1-Bis-(4-hydroxyphenyl)-3,3,5-trimethylcyclohexan und die Copolycarbonate auf Basis der beiden Monomere Bisphenol A und 1,1-Bis-(4-hydroxyphenyl)-3,3,5-trimethylcyclohexan.

Das Homopolycarbonat auf Basis von Bisphenol A ist besonders bevorzugt.

In einer weiteren vorteilhaften Ausgestaltung ist die Rauhigkeit der Oberfläche der ersten Schicht (A) ≤ 2 µm, bevorzugt ≤ 1 µm. Die Rauhigkeit wird gemäß der ISO 4288 bestimmt.

Die Oberfläche der ersten Schicht (A) weist bevorzugt einen Glanzgrad von ≥ 70 auf. Der Glanzgrad wird gemäß der EN ISO 2813 (Winkel 60°) bestimmt.

In einer speziellen Ausführungsform der erfindungsgemäßen UV-Schutzfolie kann die erste Schicht (A) ein Coating aufweisen. Das Coating ist bevorzugt ein dem Fachmann bekannter Hard-Coat. Besonders bevorzugt basiert der Hard-Coat auf einem vernetzten transparenten Kunststoff. Durch das Coating erhält die Oberfläche der Kunststofffolie bevorzugt eine Pencil Hardness (bestimmt nach IS015184) von ≥ 1H und < 8H und besonders bevorzugt von ≥ 2H und ≤ 5H. Das Coating kann direkt ohne Primerung auf die erste Schicht (A) aufgebracht werden. Das Coating kann auch einen UV-Absorber enthalten, der den zuvor für UV-Absorber genannten bevorzugten Ausführungsformen entspricht.

Die auf dem erfindungsgemäßen Bauelement angeordnete UV-Schutzfolie umfasst auch eine zweite Schicht (B) mit den nachstehenden Eigenschaften.

Die zweite Schicht (B) enthält Polycarbonat. Dabei kann das Polycarbonat auch als Polycarbonat/Polyester-Blend, Polycarbonat/Polycyclohexylmethanolcyclohexandicarboxylat Blend oder Polycarbonat/Polybutylenterephthalat Blend vorliegen.

In einer ganz besonders bevorzugten Ausführungsform der Erfindung ist die zweite Schicht B aus Polycarbonat hergestellt.

Besonders bevorzugt ist das Homopolycarbonat auf Basis von Bisphenol A.

Die zweite Schicht (B) kann geringe Mengen eines UV-Absorbers enthalten. Die zweite Schicht (B) kann 0,01 bis 0,3 Gew.-%, bevorzugt 0,01 bis 0,1 Gew.-% eines UV-Absorbers enthalten. Der UV-Absorber ist bevorzugt ein organischer UV-Absorber und ist beispielsweise ausgewählt aus der Gruppe Benzotriazol-Derivate, Dimere Benzotriazol-Derivate, Triazin-Derivate, Dimere Triazin-Derivate, Diarylcyanoacrylate oder Gemische der vorstehend genannten Verbindungen. In einer bevorzugten Ausbildung der Erfindung ist der UV-Absorber ein Triazin-Derivat. In einer weiteren Ausführung der Erfindung enthält die zweite Schicht (B) jedoch keinen UV Absorber.

Die zweite Schicht (B) weist bevorzugt eine Schichtdicke von ≥ 30und ≤ 700 µm, besonders bevorzugt von ≥ 50 und ≤ 500 µm und ganz besonders bevorzugt von ≥ 140 und ≤ 300 µm auf. Bevorzugt weist die Oberfläche der zweite Schicht (B) einen Glanzgrad, bestimmt nach EN ISO 2813 (Winkel 60°) von ≥ 60, besonders bevorzugt ≥ 90 und ganz besonders bevorzugt ≥ 95 auf. Des Weiteren bevorzugt weist die Oberfläche der zweiten Schicht (B) eine Rauhigkeit, bestimmt nach ISO 4288 von ≤ 2 µm, besonders bevorzugt ≤ 1 µm auf.

In einer weiteren Ausgestaltung der Erfindung, kann die zweite Schicht (B) auch eine strukturierte und matte Oberfläche aufweisen. In diesem Fall ist die matte Oberfläche vorzugsweise mittels der dem Bauelement zugewandten Oberfläche der Kunststofffolie gebildet. Diese Oberfläche weist dann bevorzugt einen Glanzgrad von ≤ 50 und eine Rauhigkeit von ≥ 15 µm auf.

Sowohl die erste Schicht (A), als auch die zweite Schicht (B) der erfindungsgemäßen Folien können zusätzlich Additive, wie beispielsweise Verarbeitungshilfsmittel enthalten. Dies umfasst insbesondere Entformungsmittel, Fließmittel, Stabilisatoren, insbesondere Thermostabilisatoren, Antistatika und/oder optische Aufheller. In jeder Schicht können dabei unterschiedliche Additive bzw. unterschiedliche Konzentrationen von Additiven vorhanden sein. Vorzugsweise enthält(enthalten) die erste Schicht (A) die Antistatika oder Entformungsmittel.

Beispiele für geeignete Antistatika sind kationaktive Verbindungen, beispielsweise quartäre Ammonium-, Phosphonium- oder Sulfoniumsalze, anionaktive Verbindungen, beispielsweise Alkylsulfonate, Alkylsulfate, Alkylphosphate, Carboxylate in Form von Alkali- oder Erdalkalimetallsalzen, nichtionogene Verbindungen, beispielsweise Polyethylenglykolester, Polyethylenglykolether, Fettsäureester, ethoxylierte Fettamine. Bevorzugte Antistatika sind quartäre Ammonium-Verbindungen, wie z.B. Dimethyldiisopropylammoniumperfluorbutansulfonat.

Bevorzugt werden für Polycarbonate geeignete Stabilisatoren eingesetzt. Geeignete Stabilisatoren sind beispielsweise Phosphine, Phosphite oder Si enthaltende Stabilisatoren und weitere in EP-A 0 500 496 beschriebene Verbindungen. Beispielhaft seien Triphenylphosphite, Diphenylalkylphosphite, Phenyldialkylphosphite, Tris-(nonylphenyl)phosphit, Tetrakis-(2,4-di-tert.-butylphenyl)-4,4'-biphenylen-diphosphonit, Bis(2,4-dicumylphenyl)petaerythritoldiphosphit und Triarylphosphit genannt. Besonders bevorzugt sind Triphenylphosphin und Tris-(2,4-di-tert.-butylphenyl)phosphit.

Geeignete Entformungsmittel sind beispielsweise die Ester oder Teilester von ein- bis sechswertigen Alkoholen, insbesondere des Glycerins, des Pentaerythrits oder von Guerbetalkoholen.

Einwertige Alkohole sind beispielsweise Stearylalkohol, Palmitylalkohol und Guerbetalkohole, ein zweiwertiger Alkohol ist beispielsweise Glycol, ein dreiwertiger Alkohol ist beispielsweise Glycerin, vierwertige Alkohole sind beispielsweise Pentaerythrit und Mesoerythrit, fünfwertige Alkohole sind beispielsweise Arabit, Ribit und Xylit, sechswertige Alkohole sind beispielsweise Mannit, Glucit (Sorbit) und Dulcit.

Die Ester sind bevorzugt die Monoester, Diester, Triester, Tetraester, Pentaester und Hexaester oder deren Mischungen, insbesondere statistische Mischungen, aus gesättigten, aliphatischen C₁₀ bis C₃₆-Monocarbonsäuren und gegebenenfalls Hydroxy-Monocarbonsäuren, vorzugsweise mit gesättigten, aliphatischen C₁₄ bis C₃₂-Monocarbonsäuren und gegebenenfalls Hydroxy-Monocarbonsäuren.

Die kommerziell erhältlichen Fettsäureester, insbesondere des Pentaerythrits und des Glycerins, können herstellungsbedingt weniger als 60 % unterschiedlicher Teilester enthalten.

Gesättigte, aliphatische Monocarbonsäuren mit 10 bis 36 C-Atomen sind beispielsweise Caprinsäure, Laurinsäure, Myristinsäure, Palmitinsäure, Stearinsäure, Hydroxystearinsäure, Arachinsäure, Behensäure, Lignocerinsäure, Cerotinsäure und Montansäuren.

Die erfindungsgemäße UV-Schutzfolie kann auch organische Farbstoffe, anorganische Farbpigmente, Fluoreszenzfarbstoffe und besonders bevorzugt optische Aufheller enthalten.

Die UV-Schutzfolie ist bevorzugt frei von Partikeln oder Füllstoffen mit streuenden Eigenschaften.

Die UV-Schutzfolie ist bevorzugt frei von Regionen mit streuenden Eigenschaften. Dies kann z.B. wünschenswert sein kann, wenn die Folie vollständig klar sein soll, z.B. um bei einer spiegelnden OLED die Spiegeleigenschaft nicht zu beeinträchtigen. Als Regionen mit streuenden Eigenschaften werden dabei insbesondere Partikel mit streuenden Eigenschaften und beliebige Stoffe mit streuenden Eigenschaften und Hohlräume (insbesondere Gaseinschlüsse) mit streuenden Eigenschaften bezeichnet. Besonders bevorzugt ist die UV-Schutzfolie frei von Regionen mit für sichtbares Licht, d.h. Licht im sichtbaren Spektralbereich von 380 nm bis 780 nm, streuenden Eigenschaften.

Vorzugsweise ist eine sich auf einer der aktiven organischen Schicht abgewandten Seite über die gesamte erste Schicht erstreckende Schichtoberfläche der ersten Schicht frei von regelmäßig angeordneten geometrischen Strukturelementen. Dies kann z.B. wünschenswert sein kann, wenn die Folie vollständig glatt sein soll, z.B. um bei einer spiegelnden OLED die Spiegeleigenschaft nicht zu beeinträchtigen. Unter regelmäßig angeordneten Strukturelementen wird hierbei verstanden, dass entweder die Strukturelemente selbst jeweils ein oder mehrere Symmetrieelemente (insbesondere Symmetrieebenen) aufweisen oder dass eine durch eine Vielzahl (d.h. zumindest 3 oder zumindest 5 oder sogar zumindest 10) von Strukturelementen gebildete Struktur Symmetrieelemente (beispielsweise Parallelverschiebungen) aufweist.

Die zuvor genannte flächige Oberfläche der ersten Schicht (A) kann zu der aktiven organischen Schicht parallel sein.

Vorzugsweise ist eine sich auf einer der aktiven organischen Schicht abgewandten Seite über die gesamte erste Schicht erstreckende Schichtoberfläche der ersten Schicht frei von Hervorstehungen auf der Schichtoberfläche und/oder Vertiefungen in der Schichtoberfläche mit einer Höhe bzw. Tiefe von mehr als 2 µm, besonders bevorzugt mehr als 1 µm. Dies kann z.B. wünschenswert sein kann, wenn die Folie vollständig glatt sein soll, z.B. um bei einer spiegelnden OLED die Spiegeleigenschaft nicht zu beeinträchtigen. Insbesondere kann die sich auf einer der aktiven organischen Schicht abgewandten Seite über die gesamte erste Schicht erstreckende Schichtoberfläche der ersten Schicht frei sein von Hervorstehungen auf der Schichtoberfläche und/oder Vertiefungen in der Schichtoberfläche mit einer Höhe bzw. Tiefe von mehr als 2 µm, besonders bevorzugt mehr als 1 µm, relativ zu einer Hauptebene dieser Schichtoberfläche. Diese Hauptebene kann z.B. mittlere Ebene der Schichtoberfläche sein, insbesondere eine mittlere Ebene der Schichtoberfläche, deren mittlerer quadratischer Abstand (senkrecht zu der mittleren Ebene gemessen) zu der Schichtoberfläche minimal ist.

Die erste Schicht (A) und die zweite Schicht (B) der UV-Schutzfolie des erfindungsgemäßen Bauelements können durch Coextrusion oder durch das Verbinden separater vorgefertigter Folien durch beispielsweise Kaschieren oder Laminieren zusammengeführt werden. In einer bevorzugten Ausführungsform der Erfindung sind die erste und die zweite Schicht coextrudiert ausgeführt.

Zur Herstellung einer Folie durch Extrusion wird das Kunststoffgranulat, beispielsweise das Polycarbonatgranulat einem Fülltrichter eines Extruders zugeführt und gelangt über diesen in das Plastifiziersystem bestehend aus Schnecke und Zylinder. Im Plastifiziersystem erfolgt das Fördern und Aufschmelzen des Kunststoffmaterials. Die Kunststoffschmelze wird durch eine Breitschlitzdüse gedrückt. Zwischen Plastifiziersystem und Breitschlitzdüse können eine Filtereinrichtung, eine Schmelzpumpe, stationäre Mischelemente und weitere Bauteile angeordnet sein. Die die Düse verlassende Schmelze gelangt auf einen Glättkalander. Eine glatte und/oder glänzende Oberfläche wird vorzugsweise mit polierten Metallwalzen hergestellt. Zur einseitigen Strukturierung der Folienoberfläche der zweiten Schicht kann eine Gummi-Walze eingesetzt werden. Im Walzenspalt des Glättkalanders erfolgt die endgültige Formgebung. Die für die Strukturierung der Folienoberfläche vorzugsweise verwendeten Gummi-Walzen werden in US 4 368 240 beschrieben. Eine glatte und/oder glänzende Oberfläche wird vorzugsweise mit polierten Metallwalzen hergestellt. Die Formfixierung erfolgt letztendlich durch Abkühlung und zwar wechselseitig auf den Glättwalzen und an der Umgebungsluft. Die weiteren Einrichtungen des Plastifizierungssystems dienen dem Transport, dem eventuell gewünschten Aufbringen von Schutzfolien und dem Aufwickeln der extrudierten Folien.

Die UV-Schutzfolie weist bevorzugt eine Dicke von ≥ 35 µm und ≤ 1000 µm, besonders bevorzugt von ≥ 90 µm und ≤ 600 µm und ganz besonders bevorzugt von ≥ 100 µm und ≤ 400 µm auf.

Als Folie ist im Zweifel eine Schicht oder ein Schichtverbund anzusehen, die bzw. der das Eigengewicht nicht trägt, also nicht freitragend ausgebildet ist, und insbesondere flexibel ist.

Alternativ kann im Rahmen der Erfindung auch eine UV-Schutzschicht, z.B. mit einer Dicke von bis zu 10 mm, eingesetzt werden, die eventuell keinen Foliencharakter mehr aufweist. Eine UV-Schutzschicht mit Foliencharakter eignet sich jedoch, insbesondere aufgrund der Flexibilität, besonders.

Ferner ist die UV-Schutzfolie bevorzugt auf ein bereits vorgefertigtes, funktionsfähiges Bauelement aufgebracht und an dem Bauelement befestigt. Es ist demnach insbesondere nicht notwendig, alle Bauelemente einer Herstellungscharge mit einer UV-Schutzfolie auszustatten. Vielmehr können anwendungsspezifisch lediglich ausgewählte Bauelemente mit einer UV-Schutzfolie versehen werden.

In einer bevorzugten Ausführungsform der Erfindung umfasst das erfindungsgemäße Bauelement ein Substrat, auf dem die organische Schicht angeordnet sein kann. Die UV Schutzfolie kann dabei auf der von der organischen Schicht abgewandten Seite des Substrats, auf derselben Seite auf der auch die organische Schicht aufgebracht ist oder auch auf beiden Seiten angeordnet sein. Bevorzugt ist die UV Schutzfolie mit dem Substrat verbunden. Ebenfalls bevorzugt ist die erste Schicht (A) der UV Schutzfolie dem Substrat abgewandt und die zweite Schicht (B) dem Substrat zugewandt angeordnet.

Das Substrat kann insbesondere derart ausgebildet sein, dass darauf die organische Schicht und gegebenenfalls Elektroden zur elektrischen Kontaktierung und/oder weitere Elemente des Bauelements aufgebracht sind.

Zweckmäßigerweise stabilisiert das Substrat die aktive organische Schicht mechanisch. Aufgrund der gegenüber einer Folie in der Regel hohen mechanischen Stabilität des Substrats kann die UV-Schutzfolie an dem Substrat besonders einfach stabil und vorzugsweise dauerhaft befestigt werden. Zweckmäßigerweise ist das Substrat freitragend ausgebildet.

Alternativ kann das Substrat flexibel ausgebildet sein. Für eine flexible Ausbildung eignet sich zum Beispiel eine Folie, insbesondere eine Kunststoff-Folie, z.B. eine PMMA-Folie. Durch die UV-Schutzfolie kann die mechanische Stabilität des Substrat/ UV-Schutzfolie -Verbunds gegenüber einem flexiblen Substrat, das nicht mit einer UV-Schutzfolie versehen ist, erhöht werden.

Das Substrat kann ein transparentes Substrat sein. Das Substrat kann jedoch auch ein nicht transparentes Substrat sein.

Beispielsweise kann das Substrat Glas, Quarz, Metall, Metallfolien, Folien aus Kunststoff, Halbleiterwafer wie etwa Siliziumwafer oder eine Germaniumwafer oder Wafer basierend auf Phosphor- und/oder Stickstoff-haltigen Halbleitermaterialien oder ein beliebiges anderes geeignetes Substratmaterial umfassen.

In einer bevorzugten Ausführungsform des erfindungsgemäßen Bauelements ist das Substrat für die in der aktiven Schicht erzeugte Strahlung durchlässig, also insbesondere aus einem strahlungsdurchlässigen Material gebildet. Die von der aktiven Schicht abgewandte Seite des Substrats kann so eine Strahlungsaustrittsfläche des Bauelements bilden. Beispielsweise enthält das Substrat ein Glas. Ein Glassubstrat wird insbesondere bei OLEDs häufig eingesetzt.

Das Substrat kann ferner elektrisch isolierend ausgebildet sein. Die elektrische Kontaktierung des Bauelements erfolgt in diesem Falle vorzugsweise auf der der UV-Schutzfolie abgewandten Seite des Substrats.

Das Substrat kann weiterhin im Wesentlichen vollflächig mit der UV-Schutzfolie versehen sein. Bevorzugt überdeckt die UV-Schutzfolie zumindest die aktive organische Schicht vollständig.

In einer bevorzugten Ausbildung des erfindungsgemäßen Bauelements, ist das Substrat aus einem splitterfähigen Material gebildet und die UV-Schutzfolie derart mechanisch stabil ausgebildet und mit dem Substrat verbunden, dass ein gesplittertes Substrat mittels der UV-Schutzfolie zusammengehalten wird.

Die UV- Schutzfolie ist hierzu zweckmäßigerweise mit einer geeigneten mechanischen Stabilität ausgebildet und vorzugsweise dauerhaft mit dem Substrat verbunden.

Über die UV-Schutzfolie kann so die Gesamtstabilität des Verbundes von Substrat und Folie und darüber die des gesamten Bauelements vorteilhaft erhöht werden. Weiterhin wird die Gefahr von durch Splitter hervorgerufenen Verletzungen bei der Handhabung des Bauelements verringert.

Mittels der aktiven organischen Schicht wird vorzugsweise sichtbares Licht erzeugt. Die aktive organische Schicht kann eine einzelne organische Schicht oder einen Schichtstapel mit einer Mehrzahl organischer Schichten enthalten. Die organische Schicht, beziehungsweise die organischen Schichten enthalten bevorzugt ein halbleitendes organisches Material.

Beispielsweise enthält die organische Schicht ein halbleitendes Polymer. Geeignete organische oder organometallische Polymere umfassen: Polyfluorene, Polythiopene, Polyphenylene, Polythiophenvinylene, Poly-p-Phenylenvinylene, Polyspiro Polymere und ihre Familien, Copolymere, Derivate und Mischungen davon. Diese Polymere sind insbesondere mittels nasschemischen Verfahren, wie beispielsweise Spin Coating, abscheidbar.

Alternativ oder ergänzend zu Polymermaterialien kann die organische Schicht ein niedermolekulares Material (sogenannte Small-Molecules) enthalten. Geeignete Materialien mit niedrigem Molekulargewicht (niedermolekulare Materialien) sind beispielsweise Tris-8-aluminium-quinolinol-Komplexe und Cumarine.

Auch kann das Bauelement gegebenenfalls eine Mehrzahl von, vorzugsweise strukturierten, voneinander getrennten organischen Schichten oder Schichtstapeln umfassen. Die verschiedenen Schichten bzw. Schichtstapel können zur Erzeugung verschiedenfarbigen Lichts, z.B. rotem, grünem bzw. blauem Licht, ausgebildet sein.

Zur Ladungsträgerinjektion in die aktive organische Schicht kann diese elektrisch leitend mit einer ersten Elektrode und einer zweiten Elektrode verbunden sein. Über diese Elektroden können der organischen Schicht Ladungsträger - Elektronen bzw. Löcher - zur Strahlungserzeugung durch Rekombination in der organischen Schicht zugeführt werden. Die Elektroden sind vorzugsweise schichtartig ausgebildet, wobei die organische Schicht besonders bevorzugt zwischen den Elektroden angeordnet ist.

Die erste Elektrode kann beispielsweise eine Anode sein und ist bevorzugt aus Indium-dotiertem Zinnoxid (ITO), Fluor-Zinn-Oxid (FTO), Aluminium-Zink-Oxide (AZO) oder Antimon-Zinn-Oxid (ATO) gebildet. Die erste Elektrode kann eine Anode oder eine Kathode sein. Die erste Elektrode kann lochinjizierende oder elektroneninjizierende Funktionen aufweisen. Die erste Elektrode kann zumindest teilweise transparent für die in der aktiven organischen Schicht erzeugt Strahlung sein, bevorzugt ist die erste Elektrode transparent ausgebildet. Die erste Elektrode kann mittels Sputterns oder mittels thermischen Verdampfens aufgebracht werden. Die erste Elektrode kann eine Schichtdicke aufweisen in einem Bereich von ungefähr 5 nm bis ungefähr 300 nm, bevorzugt von ungefähr 100 nm bis ungefähr 200 nm.

Die zweite Elektrode kann gebildet werden, indem eine Metallschicht mit einer Schichtdicke von 5 nm bis ungefähr 1000 nm, bevorzugt von ungefähr 100 nm bis ungefähr 300 nm aufgebracht wird. Die Metallschicht kann mindestens eines der folgenden Metalle aufweisen: Aluminium, Barium, Indium, Silber,· Kupfer, Gold, Magnesium, Samarium, Platin, Palladium, Calcium und Lithium sowie Kombinationen derselben oder dieses Metall oder eine Verbindung aus diesem Metall oder aus mehreren dieser Metalle, beispielsweise eine Legierung.

Die die Metallschicht aufweisende zweite Elektrode ist beispielsweise, wenn die erste Elektrode eine Anode ist, eine Kathode.

Die zweite Elektrode kann gegebenenfalls als Mehrschichtstruktur ausgeführt sein. Bevorzugt ist eine der Schichten für die Ladungsträgerinjektion in die organische Schicht und eine weitere Schicht der zweiten Elektrode als Spiegelschicht ausgebildet. Die Schicht für die Ladungsträgerinjektion ist zweckmäßigerweise zwischen der Spiegelschicht und der organischen Schicht angeordnet. Die Spiegelschicht und/oder die Ladungsträgerinjektionsschicht können die oben angeführten Metalle, enthalten oder daraus bestehen, wobei die beiden Schichten zweckmäßigerweise unterschiedliche Metalle enthalten.

Das erfindungsgemäße Bauelement kann auch eine Verkapselung für die organische Schicht aufweisen. Eine derartige Verkapselung kapselt die organische Schicht gegenüber schädlichen äußeren Einflüssen, wie Feuchtigkeit, ab. Derartige Verkapselungen sind beispielsweise in der DE 10 2011079 160 A1 beschrieben. Die Verkapselung kann z.B. als Dachkonstruktion ausgebildet sein. In einer bevorzugten Ausführungsform ist die Verkapselung transparent ausgeführt.

Eine Ansteuerschaltung des Bauelements kann auf dem Substrat - gegebenenfalls innerhalb der Verkapselung - angeordnet sein.

Das erfindungsgemäße Bauelement kann als "Top-Emitter", als "Bottom-Emitter" oder beidseitig transparent ausgeführt sein.

Ganz allgemein gilt, dass bei einem "Top-Emitter" oder einem "Bottom-Emitter" eine Elektrode der strahlungsemittierenden Vorrichtung gemäß verschiedenen Ausführungsbeispielen transparent und die andere Elektrode reflektierend ausgeführt sein kann. Alternativ dazu können auch beide Elektroden transparent ausgeführt sein.

Der Begriff "Bottom-Emitter", wie er hierin verwendet wird, bezeichnet eine Ausführung, die zu der Substratseite des Bauelements hin transparent ausgeführt ist. Beispielsweise können dazu wenigstens das Substrat und die erste Elektrode transparent ausgeführt sein. Die erste Elektrode ist bei dieser Ausführungsform bevorzugt direkt auf dem Substrat angeordnet. Die zweite Elektrode ist bevorzugt auf der vom Substrat abgewandten Seite der aktiven organischen Schicht angeordnet. Ein als "Bottom-Emitter" ausgeführtes Bauelement kann demnach beispielsweise in der aktiven organischen Schichten erzeugte Strahlung auf der Substratseite des Bauelements emittieren.

Der Begriff "Top-Emitter", wie er hierin verwendet wird, bezeichnet beispielsweise eine Ausführung, bei der die zweite Elektrode bevorzugt direkt auf dem Substrat angeordnet ist. Die erste Elektrode ist bevorzugt transparent ausgeführt und auf der vom Substrat abgewandten Seite der aktiven organischen Schicht angeordnet. Eine als "Top-Emitter" ausgeführtes Bauelement kann demnach beispielsweise in der aktiven organischen Schicht erzeugte Strahlung auf der Seite der ersten Elektrode des Bauelements emittieren.

Eine beidseitig transparente Kombination aus "Bottom-Emitter" und "Top-Emitter" ist ebenso vorgesehen. Bei einer solchen Ausführung ist das Bauelement allgemein in der Lage, das in den organischen Funktionsschichten erzeugte Licht in beide Richtungen - also sowohl zu der Substratseite als auch zu der Seite der zweiten Elektrode hin - zu emittieren.

Diese Ausführungsform des erfindungsgemäßen Bauelements weist damit zwei Strahlungsauskopplungsseiten auf. Die UV-Schutzfolie kann auf einer der beiden Strahlungsauskopplungsseiten, aber auch auf beiden Strahlungsauskopplungsseiten angeordnet sein.

In einer bevorzugten Ausführungsform des erfindungsgemäßen Bauelements, ist die zweite Schicht (B) der UV-Schutzfolie an das Bauelement brechungsindexangepasst.

Der Strahlungsübertritt von Strahlung aus dem Bauelement in die zweite Schicht (B) der UV-Schutzfolie wird so erleichtert und die Reflexionsverluste an der Grenzfläche(n) zwischen Bauelement und UV-Schutzfolie werden gemindert. Für die Brechungsindexanpassung weicht der Brechungsindex des Materials der zweiten Schicht (B) bevorzugt um 8% oder weniger von dem Brechungsindex des seitens des Bauelements angeordneten Materials, insbesondere dem Brechungsindex des Substrats ab.

Für die Brechungsindexanpassung kann ein entsprechend geeignetes Material für die zweite Schicht (B) eingesetzt werden. Zur Brechungsindexanpassung an ein Glassubstrat ist beispielsweise ein Polycarbonat für die zweite Schicht (B) besonders geeignet.

Alternativ oder ergänzend kann ein Brechungsindexanpassungsmaterial, z.B. ein optisches Gel für die Brechungsindexanpassung, eingesetzt werden, das zwischen der zweiten Schicht (B) der UV-Schutzfolie und dem Substrat angeordnet ist. Mit Vorzug mindert das Brechungsindexanpassungsmaterial den Brechungsindexsprung vom Substrat zur zweiten Schicht (B) der UV-Schutzfolie.

In einer weiteren vorteilhaften Ausgestaltung ist die UV-Schutzfolie an dem Bauelement befestigt. Bevorzugt ist die UV-Schutzfolie an dem Bauelement, insbesondere dem Substrat, mittels eines Haftvermittlers befestigt oder die UV-Schutzfolie ist auf das Bauelement, insbesondere das Substrat auflaminiert. Als Haftvermittler eignet sich beispielsweise ein druckempfindlicher Kleber, wie zum Beispiel der Optically Clear Adhesive OCA 8212 der Firma 3M.

Wird ein Haftvermittler eingesetzt, so kann dieser mit Vorteil zugleich als Brechungsindexanpassungsmaterial dienen. Hierzu weist der Haftvermittler bevorzugt einen Brechungsindex auf, der nicht um mehr als 10%, bevorzugt nicht mehr als 8% außerhalb eines durch die Brechungsindices des Substrats und des Materials der zweiten Schicht (B) der UV-Schutzfolie begrenzten Intervalls liegt. Vorzugsweise weist das Brechungsindexanpassungsmaterial einen Brechungsindex auf, der zwischen dem des Substrats und dem Material der zweiten Schicht (B) der UV-Schutzfolie liegt.

In einer weiteren bevorzugten Ausgestaltung ist ein antistatisch wirkendes Element, insbesondere seitens der Strahlungsauskoppelseite, mit dem Bauelement verbunden. Schmutzanlagerungen am Bauelement können hierüber vermindert werden. Als besonders vorteilhaft hat es sich erwiesen, die UV-Schutzfolie antistatisch auszubilden. Elektrostatisch verursachte Anlagerungen an der Folie, welche sich nachteilig auf die austrittsseitige Strahlungsleistungsverteilung auswirken können, werden so vermindert. Ein Antistatikum kann mit Vorteil in der UV-Schutzfolie integriert sein. Dabei kann das Antistatikum in der ersten Schicht A) und/oder der zweiten Schicht B) und/oder in dem auf der ersten Schicht A) angebrachten Coating der UV-Schutzfolie integriert sein.

Alternativ kann das antistatisch wirkendes Element als separate Antistatikfolie in einem, insbesondere gemeinsam mit der UV-Schutzfolie coextrudierten Folienverbund vorgesehen sein.

Ein weiterer Gegenstand der Erfindung ist die Verwendung des erfindungsgemäßen Bauelements als organisches strahlungsemittierendes Bauelement, insbesondere als organische lichtemittierende Diode (OLED). Die aktive Schicht ist hierbei zweckmäßigerweise mittels einer organischen Schicht gebildet, die ein organisches (halb)leitendes Material enthält. Die organische Schicht enthält dabei zum Beispiel zumindest ein (halb)leitendes Polymer und/oder umfasst zumindest eine Schicht mit einem (halb)leitenden Molekül, insbesondere einem niedermolekularen Molekül.

Eine vorgefertigte OLED kann insbesondere Elektroden für die elektrische Kontaktierung und, alternativ oder zusätzlich, eine die organische Schicht schützende Verkapselung, welche die organische Schicht beispielsweise vor Feuchtigkeit schützt, umfassen.

Ein weiterer Gegenstand der Erfindung ist die Verwendung des erfindungsgemäßen Bauelements zur Beleuchtung, insbesondere zur Allgemeinbeleuchtung. Das Bauelement kann beispielsweise zur Innenraumbeleuchtung, zur Außenraumbeleuchtung oder in einer Signalleuchte eingesetzt werden.

Weitere Merkmale, Vorteile und Zweckmäßigkeit der Erfindung ergeben sich aus der folgenden Beschreibung der Ausführungsbeispiele in Verbindung mit den Figuren.

Figuren 1a und 1b zeigt ein Ausführungsbeispiel eines erfindungsgemäßen strahlungsemittierenden Bauelements anhand einer vereinfachten schematischen Schnittansicht für einen "Top-Emitter".

Figur 2a und 2b zeigt ein weiteres Ausführungsbeispiel eines erfindungsgemäßen strahlungsemittierenden Bauelements anhand einer vereinfachten schematischen Schnittansicht für einen "Bottom-Emitter".

Figur 3a und 3b zeigt ein weiteres Ausführungsbeispiel eines erfindungsgemäßen strahlungsemittierenden Bauelements anhand einer vereinfachten schematischen Schnittansicht eines beidseitig transparenten Bauelementes.

Gleiche, gleichartige und gleich wirkende Elemente sind in den Figuren mit gleichen Bezugszeichen versehen

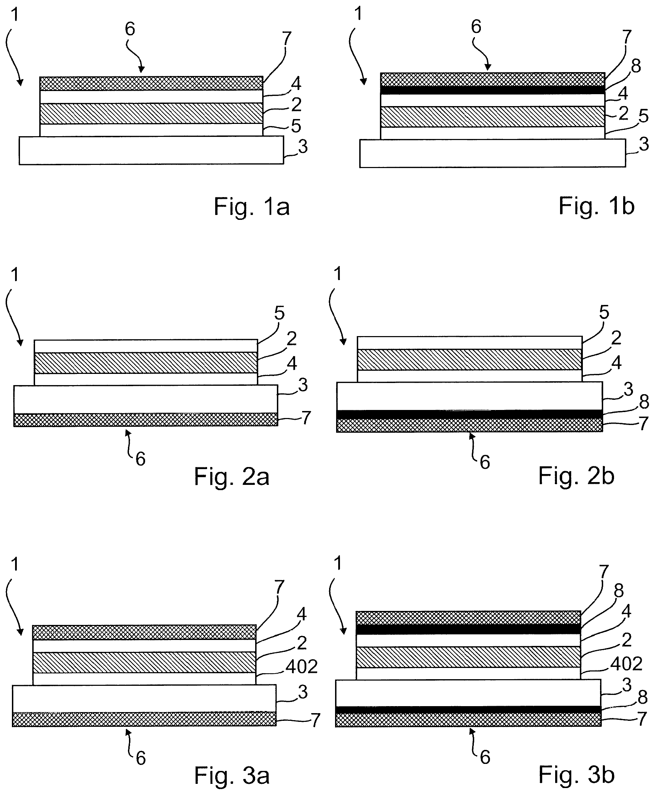

Die Figuren 1a und 1b zeigen jeweils ein Ausführungsbeispiel eines erfindungsgemäßen strahlungsemittierenden Bauelements anhand einer vereinfachten schematischen Schnittansicht für einen "Top-Emitter" und werden im Folgenden näher erläutert.

Das strahlungsemittierende Bauelement 1 in den Figuren Ia und Ib ist jeweils als OLED ausgeführt. Das Bauelement 1 umfasst eine zur Strahlungserzeugung ausgebildete aktive organische Schicht 2. Die organische Schicht 2 ist auf einem Substrat 3 des strahlungsemittierenden Bauelements angeordnet und mit diesem verbunden.

Zur Ladungsträgerinjektion in die organische Schicht 2 ist diese elektrisch leitend mit einer ersten, transparenten Elektrode 4 und einer zweiten reflektierenden Elektrode 5 verbunden. Über diese Elektroden 4, 5 können der organischen Schicht Ladungsträger - Elektronen bzw. Löcher - zur Strahlungserzeugung durch Rekombination in der organischen Schicht 2 zugeführt werden. Die Elektroden 4 und 5 sind schichtartig ausgebildet, und die organische Schicht ist zwischen den Elektroden angeordnet. Die Elektroden und die organische Schicht 2 sind auf das Substrat 3 aufgebracht. Bevorzugt ist die zweite Elektrode 5 als reflektierende Elektrode und damit zugleich als Spiegelschicht ausgebildet. Hierzu ist die Elektrode 5 vorzugsweise metallisch oder auf Legierungsbasis, typischerweise als Aluminium oder Silber Legierung ausgeführt. Eine separate Spiegelschicht ist in den Figuren nicht explizit gezeigt. Die zweite Elektrode 5 ist bevorzugt zwischen dem Substrat 3 und der organischen Schicht 2 angeordnet. Für den Strahlungsdurchtritt ist die erste Elektrode 4 zweckmäßigerweise strahlungsdurchlässig ausgebildet. Beispielsweise enthält die Elektrode hierzu ein Indiumzinnoxid (ITO: Indium Tin Oxide).

Das Substrat 3 kann bei einem "Top-Emitter" strahlungsdurchlässig oder strahlungsundurchlässig ausgeführt sein. Das Substrat 3 kann aus Glas, beispielsweise aus Borofloat-Glas, einer Metallfolie oder einem Metallblech aus beispielsweise Aluminium oder Kupfer, oder einem polymeren Material, wie beispielsweise Polyethylenterephthalat (PET) hergestellt werden.

Durch die dem Substrat gegenüber liegende Seite des Bauelements 1 hindurch tretendes Licht kann aus dem Bauelement 1 auskoppeln, daher wird diese als Strahlungsauskopplungsseite 6 bezeichnet. Auf der Strahlungsauskoppelseite 6 des Bauelements 1, ist eine UV-Schutzfolie 7 angebracht.

Auf die Darstellung einer Verkapselung für die organische Schicht 2 und die Elektroden 4 und 5, die vorzugsweise zwischen der UV-Schutzfolie 7 und der ersten Elektrode 4 aufgebracht ist , wurde aus Übersichtlichkeitsgründen verzichtet.

Auch auf eine explizite Darstellung der elektrischen Kontaktierung des Bauelements wurde ebenfalls verzichtet. So kann z.B. eine Ansteuerschaltung des Bauelements auf dem Substrat - gegebenenfalls innerhalb der Verkapselung - angeordnet sein.

Im Ausführungsbeispiel gemäß Figur 1a ist die UV-Schutzfolie 7 auf die sich über der ersten Elektrode 4 befindende Verkapselung und gegebenenfalls auch auf das Substrat direkt auflaminiert, wohingegen im Ausführungsbeispiel gemäß Figur 1b eine gesonderte Haftvermittlungsschicht 8, zum Beispiel eine Kleberschicht, vorgesehen ist, über die die UV-Schutzfolie 7 befestigt ist. Als Haftvermittler 8 wird ein Optically Clear Adhesive OCA 8212 der Firma 3M eingesetzt.

Um den Strahlungsübertritt aus dem Bauelement in die UV-Schutzfolie 7 zu erleichtern, ist das Material der zweiten Schicht (B) der UV-Schutzfolie an das Material der Verkapselung, die sich über der ersten Elektrode 4 befindet, brechungsindexangepasst. Für die zweite Schicht (B) wird ein Polycarbonat mit einem Brechungsindex von ungefähr 1,59 verwendet. Dieses Material ist für den Fall, dass die oberste Schicht der Verkapselung ein Schutzlack basierend auf Epoxidsystemen mit einem Brechungsindex von ungefähr 1,55 bis 1,63 darstellt, gut brechungsindexangepasst.

Die Figuren 2a und 2b zeigen jeweils ein Ausführungsbeispiel eines erfindungsgemäßen strahlungsemittierenden Bauelements anhand einer vereinfachten schematischen Schnittansicht für einen "Bottom-Emitter".

Das strahlungsemittierende Bauelement 1 in den Figuren 2 a und 2b ist jeweils als OLED ausgeführt. Das Bauelement 1 umfasst eine zur Strahlungserzeugung ausgebildete aktive organische Schicht 2. Die organische Schicht 2 ist auf einem Substrat 3 des strahlungsemittierenden Bauelements angeordnet und mit diesem verbunden.

Zur Ladungsträgerinjektion in die organische Schicht 2 ist diese elektrisch leitend mit einer ersten, transparenten Elektrode 4 und einer zweiten reflektierenden Elektrode 5 verbunden. Über diese Elektroden 4 und 5 können der organischen Schicht Ladungsträger - Elektronen bzw. Löcher - zur Strahlungserzeugung durch Rekombination in der organischen Schicht 2 zugeführt werden. Die Elektroden 4 und 5 sind schichtartig ausgebildet, und die organische Schicht ist zwischen den Elektroden angeordnet. Die Elektroden und die organische Schicht 2 sind auf das Substrat 3 aufgebracht. Bevorzugt ist die zweite Elektrode 5 als reflektierende Elektrode und damit zugleich als Spiegelschicht ausgebildet. Hierzu ist die Elektrode 5 vorzugsweise metallisch oder als Aluminium oder Silber Legierung ausgeführt. Eine separate Spiegelschicht ist in den Figuren nicht explizit gezeigt. Die erste Elektrode 4 ist bevorzugt zwischen dem Substrat 4 und der organischen Schicht 2 angeordnet. Für den Strahlungsdurchtritt ist die erste Elektrode 4 zweckmäßigerweise strahlungsdurchlässig ausgebildet. Beispielsweise enthält die Elektrode hierzu ein Indiumzinnoxid (ITO: Indium Tin Oxide).

Das Substrat 3 ist strahlungsdurchlässig für in der organischen Schicht 2 erzeugte Strahlung ausgebildet. Mittels der organischen Schicht 2 wird sichtbares Licht erzeugt. Als strahlungsdurchlässiges Substrat kann beispielsweise ein Glassubstrat aus Borofloat-Glas eingesetzt werden.

Durch die der organischen Schicht 2 abgewandte Fläche des Substrats 3 hindurch tretendes Licht kann aus dem Bauelement 1 auskoppeln, daher wird diese als Strahlungsauskopplungsseite 6 bezeichnet. Auf der Strahlungsauskoppelseite 6 des Bauelements 1, ist eine UV-Schutzfolie 7 angebracht. Diese ist mit dem Substrat 3 verbunden.

Auf die Darstellung einer Verkapselung für die organische Schicht 2, die vorzugsweise auf der von der UV-Schutzfolie 7 abgewandten Seite des Substrats 4 angeordnet ist, wurde aus Übersichtlichkeitsgründen verzichtet.

Auch auf eine explizite Darstellung der elektrischen Kontaktierung des Bauelements wurde verzichtet. So kann z.B. eine Ansteuerschaltung des Bauelements auf dem Substrat - gegebenenfalls innerhalb der Verkapselung - angeordnet sein.

Im Ausführungsbeispiel gemäß Figur 2a ist die UV-Schutzfolie 7 auf das Substrat 3 auflaminiert, wohingegen im Ausführungsbeispiel gemäß Figur 2b eine gesonderte Haftvermittlungsschicht 8, zum Beispiel eine Kleberschicht, vorgesehen ist, über die die UV-Schutzfolie 7 am Substrat 3 befestigt ist. Als Haftvermittler 8 wurde ein Optically Clear Adhesive OCA 8212 der Firma 3M eingesetzt.

Um den Strahlungsübertritt aus dem Substrat 4 in die UV-Schutzfolie 7 zu erleichtern, ist das Material der zweiten Schicht (B) der UV-Schutzfolie an das Substrat brechungsindexangepasst. Für die zweite Schicht (B) wurde ein Polycarbonat mit einem Brechungsindex von ungefähr 1,59 verwendet. Dieses Material ist an ein Glassubstrat, insbesondere ein Borofloat-Glassubstrat mit einem Brechungsindex von ungefähr 1,54 gut brechungsindexangepasst.

Die Figuren 3a und 3b zeigen jeweils ein Ausführungsbeispiel eines erfindungsgemäßen strahlungsemittierenden Bauelements anhand einer vereinfachten schematischen Schnittansicht für einen beidseitig transparenten Emitter.

Das strahlungsemittierende Bauelement 1 ist jeweils als OLED ausgeführt. Das Bauelement 1 umfasst eine zur Strahlungserzeugung ausgebildete aktive organische Schicht 2. Die organische Schicht 2 ist auf einem Substrat 3 des strahlungsemittierenden Bauelements angeordnet und mit diesem verbunden.

Zur Ladungsträgerinjektion in die organische Schicht 2 ist diese elektrisch leitend mit einer ersten, transparenten Elektrode 4 und einer weiteren transparenten Elektrode 402 verbunden. Über diese Elektroden 4, 402 können der organischen Schicht Ladungsträger - Elektronen bzw. Löcher - zur Strahlungserzeugung durch Rekombination in der organischen Schicht 2 zugeführt werden. Die Elektroden 4 und 402 sind schichtartig ausgebildet, und die organische Schicht ist zwischen den Elektroden angeordnet. Die Elektroden und die organische Schicht 2 sind auf das Substrat 3 aufgebracht. Bevorzugt ist eine der transparenten Elektroden 4 oder 402 als dünner Metallfilm, insbesondere aus Silber, ausgebildet. Die andere transparente Elektrode 4 oder 402 enthält bevorzugt ein Indiumzinnoxid (ITO: Indium Tin Oxide).

Das Substrat 3 ist strahlungsdurchlässig für die in der organischen Schicht 2 erzeugte Strahlung ausgebildet. Mittels der organischen Schicht 2 wird sichtbares Licht erzeugt. Als strahlungsdurchlässiges Substrat wird ein Glassubstrataus Borofloat-Glas, eingesetzt.

Durch die der organischen Schicht 2 abgewandte Fläche des Substrats 3, sowie durch die dem Substrat gegenüberliegende Seite des Bauelements hindurch tretendes Licht kann aus dem Bauelement 1 auskoppeln, daher werden diese beiden Seiten als Strahlungsauskopplungsseiten 6 und 602 bezeichnet.

Gemäß den Figuren 3a und 3b sind auf den beiden Strahlungsauskoppelseite 6 und 602 des Bauelements 1 UV-Schutzfolien 7 angebracht. Alternativ kann auch nur auf einer der beiden Strahlungsauskopplungsseiten eine UV-Schutzfolie 7 angebracht sein.

Auf die Darstellung einer Verkapselung für die organische Schicht 2 und die Elektroden 4 und 402, die vorzugsweise zwischen der UV-Schutzfolie 7 und der einen Elektrode 4 aufgebracht ist, wurde aus Übersichtlichkeitsgründen verzichtet.

Auch auf eine explizite Darstellung der elektrischen Kontaktierung des Bauelements wurde verzichtet. So kann z.B. eine Ansteuerschaltung des Bauelements auf dem Substrat - gegebenenfalls innerhalb der Verkapselung - angeordnet sein.

Im Ausführungsbeispiel gemäß Figur 3a ist die UV-Schutzfolie 7 auf die sich über der einen Elektrode 4 befindende Verkapselung und gegebenenfalls auch auf das Substrat direkt auflaminiert, wohingegen im Ausführungsbeispiel gemäß Figur 3b eine gesonderte Haftvermittlungsschicht 8, zum Beispiel eine Kleberschicht, vorgesehen ist, über die die UV-Schutzfolie 7 befestigt ist. Als Haftvermittler wird ein Optically Clear Adhesive OCA 8212 der Firma 3M eingesetzt.

Um den Strahlungsübertritt aus dem Substrat 3 in die UV-Schutzfolie 7 auf der Strahlungsauskopplungsseite 6 zu erleichtern, ist das Material der zweiten Schicht (B) der UV-Schutzfolie an das Substrat brechungsindexangepasst. Für die zweite Schicht (B) ein Polycarbonat mit einem Brechungsindex von ungefähr 1,59 verwendet. Dieses Material ist an ein Glassubstrat, insbesondere ein Borofloat-Glassubstrat mit einem Brechungsindex von ungefähr 1,54 gut brechungsindexangepasst. Auf der Strahlungsauskopplungsseite 602 befindet sich bevorzugt eine Glasabdeckung oder eine Verkapselung mit einem Schutzlack basierend auf einem Epoxidsystem als oberste Schicht. Um den Strahlungsübertritt aus dem Bauelement auch auf dieser Strahlungsauskopplungsseite 602 in die UV-Schutzfolie 7 zu erleichtern, ist das Material der zweiten Schicht (B) der UV-Schutzfolie an Glas oder das Epoxidsystem brechungsindexangepasst. Für die zweite Schicht (B) wird ein Polycarbonat mit einem Brechungsindex von ungefähr 1,59 verwendet. Dieses Material ist an das Epoxidsystemen mit einem Brechungsindex von ungefähr 1,55 bis 1,63 oder die Glasabdeckung, die sich ähnlich wie das Substratglas verhält, gut brechungsindexangepasst.

Im Folgenden werden beispielhaft Folien und deren Herstellung beschrieben, die für ein erfindungsgemäßes Bauelement, insbesondere ein sichtbares Licht emittierendes Bauelement, besonders geeignet sind.

### Verwendete Materialien:

Makrolon 3108 550115:
   Hochviskoses Bisphenol A Polycarbonat mit einem MVR von 6,0 cm³/10min (nach ISO 1133 bei 300°C und 1,2 kg)
Makrolon 2600 000000:
   Mittelviskoses Hochviskoses Bisphenol A Polycarbonat mit einem MVR von 12,5 cm³/10min (nach ISO 1133 bei 300 °C und 1,2 kg)
Tinuvin 1600:
   UV-Schutzmittel der Firma BASF, Ludwigshafen (ehemals Ciba Specialty Chemicals) (biphenylsubstituiertes Triazin der Formel I mit X=OCH₂CH(CH₂CH₃)C₄H₉)
Tinuvin 360 (2,2'-methylene-bis(6-(2H-benzotriazol-2-yl)-4-(1,1,3,3-tetramethylbutyl))-phenol):
   Niedrig flüchtiger kommerzielles UV-Schutzmittel der BASF, Ludwigshafen, aus der Gruppe der Hydroxyphenylbenzotriazole.
Plexiglas 8N:
   PMMA mit einem MVR von 3 cm³/10min (nach ISO 1133 bei 230°C und 3,8 kg) und einem Gewichtsmittleren Molekulargewicht M_{w} von 124 kg/mol (bestimmt durch Gelpermeationschromatographie in Tetrahydrofuran bei 23 °C; Kalibrierung auf Polystyrolstandards der Firma Röhm GmbH & Co. KG).

### Beispiel 1:

### Herstellung des Tinuvin 1600-UV-Schutz-Compounds:

Die Herstellung des Tinuvin 1600-UV-Schutz-Compounds (Granulat) erfolgte mit einem herkömmlichen Zweischnecken-Compoundierextruder bei für Polymethylmethacrylat üblichen Verarbeitungstemperaturen von 230 bis 285°C.

Es wurde ein Master-Batch mit folgender Zusammensetzung hergestellt:
- Plexiglas 8N der Fa. Evonik mit einem Anteil von 95 Gew.-%
- Tinuvin 1600 als farbloses Pulver mit einem Anteil von 5 Gew-%.

Zu 85 kg Plexiglas 8N wurden auf einem Zweischneckenextruder (ZSK 32) bei einer Drehzahl von 190 min⁻¹ und einem Durchsatz von 50kg/h 15 kg Pulver-Compound, bestehend aus 10 kg Plexiglas 8N-Grieß (Mittlerer Partikel-Durchmesser ca. 0,8 mm) und 5 kg_Tinuvin 1600, entspricht 5 Gew.-%) zudosiert. Die Massentemperatur betrug 278°C und das erhaltene Granulat war klar und transparent.

### Beispiel 2:

### Herstellung des -Compounds enthaltend Tinuvin® 360 als UV Absorber:

Die Herstellung des Componuds (Granulat) enthaltend Tinuvin® 360 als UV-Absorber erfolgte mit einem herkömmlichen Zweischnecken-Compoundierextruder bei für Polycarbonate üblichen Verarbeitungstemperaturen von 275 bis 300°C.

Es wurde ein Master-Batch mit folgender Zusammensetzung hergestellt:
• • 95 Gew.-% Polycarbonat Makrolon® 3108 550115 der Fa. Bayer MaterialScience AG
• • 5 Gew.-%Tinuvin® 360 als farbloses Pulver

Zu 90 kg Makrolon® 3108 550115 wurden auf einem Zweischneckenextruder (ZSK 32) bei einer Drehzahl von 175 min⁻¹ und einem Durchsatz von 50kg/h 10 kg Pulver-Compound, bestehend aus 5 kg Makrolon® 3108-Grieß (erhalten durch Mahlung aus dem Granulat) (Mittlerer Partikel-Durchmesser ca. 0,8 mm, gemessen nach ISO 13320-1(laser diffraction method)). und 5 kg Tinuvin® 360, entspricht 5 Gew.-%) zudosiert. Die Massentemperatur betrug 306°C und das erhaltene Granulat war klar und transparent.

### Herstellung einer coextrudiereten UV-Schutzfolie:

### Folien-Coextrusion

Die verwendete Anlage besteht aus
- einem Extruder mit einer Schnecke von 105 mm Durchmesser (D) und einer Länge von 41xD. Die Schnecke weist eine Entgasungszone auf;
- einen Coextruder zum Aufbringen der Deckschicht mit einer Schnecke der Länge 41 D und einem Durchmesser von 35 mm
- einem Umlenkkopf;
- eine speziellen Coextrusions-Breitschlitzdüse mit 1500 mm Breite;
- einem Dreiwalzen-Glättkalander mit horizontaler Walzenanordnung, wobei die dritte Walze um +/- 45° gegenüber der Horizontalen schwenkbar ist;
- einer Rollenbahn;
- einer Einrichtung zum beidseitigen Aufbringen von Schutzfolie;
- einer Abzugseinrichtung;
- Aufwickelstation.

Das Granulat des Basismaterials wurde dem Fülltrichter des Hauptextruders zugeführt. Im jeweiligen Plastifiziersystem Zylinder/Schnecke erfolgte das Aufschmelzen und Fördern des jeweiligen Materials. Beide Materialschmelzen wurden in der Coextrusionsdüse zusammengeführt. Von der Düse gelangt die Schmelze auf den Glättkalander, dessen Walzen die in der Tabelle 1 genannte Temperatur aufweisen. Auf dem Glättkalander erfolgt die endgültige Formgebung und Abkühlung des Materials. Zur Glättung der Oberflächen wurden polierte Chrom-Walzen eingesetzt. Anschließend wird die Folie durch einen Abzug transportiert, es wird die Schutzfolie beidseitig aufgebracht, danach erfolgt die Aufwicklung der Folie.

Es wurden folgende Verfahrensparameter gewählt:

**Tabelle 1:**

| | |
|---|---|
| Temperatur des Hauptextruders | 295 °C +/- 5°C |
| Temperatur des Coextruders | 270 °C +/-5°C |
| Temperatur des Umlenkkopfes | 285 °C +/-5°C |
| Temperatur der Düse | 300 °C +/-5°C |
| Drehzahl des Hauptextruders | 60 min⁻¹ |
| Drehzahl des Coextruders | 31 min⁻¹ |
| Temperatur der Walze 1 | 76 °C |
| Temperatur der Walze 2 | 73 °C |
| Temperatur der Walze 3 | 140 °C |
| Abzugsgeschwindigkeit | 14,6 m/min |

### Beispiel 3

### Hauptextruder:

Es wurde ein Compound folgender Zusammensetzung abgemischt:
- Tinuvin 360-UV-Schutz -Masterbatch aus Beispiel 2 und Polycarbonat Makrolon 3108 550115 der Fa. Bayer MaterialScience AG mit einem Anteil gemäß den Spalte 2 "Hauptextruder" in der Tabelle 2.

### Coextruder:

Es wurde ein Compound folgender Zusammensetzung abgemischt:
- 100 Gew.-% Tinuvin 1600-UV-Schutz -Masterbatch aus Beispiel 1

Hieraus wurde eine Folie mit beidseitig glatten Seiten auf der transparenten Polycarbonat-Schicht und der transparent PMMA-Schicht und einer Gesamtschichtdicke von 250µm extrudiert.

Die Dicke der so erhaltenen transparenten Beschichtung wurde mittels eines Eta SD 30 der Firma Eta Optik GmbH bestimmt.

### Beispiel 4 (nicht erfindungsgemäß)

### Hauptextruder:

Für die Hauptschicht wurde folgendes Material eingesetzt:
- Polycarbonat Makrolon 3108 550115 der Fa. Bayer MaterialScience AG mit einem Anteil gemäß den Spalte 2 "Hauptextruder" in der Tabelle 2

### Coextruder:

Es wurde ein Compound folgender Zusammensetzung abgemischt:
- 100 Gew.-% Tinuvin 360-UV-Schutz -Masterbatch aus Beispiel 2

Hieraus wurde eine Folie mit beidseitig glatten Seiten auf der transparenten Polycarbonat-Schicht und der transparenten UV-geschützten Polycarbonat-Schicht und einer Gesamtschichtdicke von 250µm extrudiert.

**Tabelle 2:**

| | Hauptextruder | Coextruder |
|---|---|---|
| Beispiel 3 | 235µm 6% Compound aus Beispiel 3 + 94% M. 3108 550115 | 15µm 100% Compound aus Beispiel 1 |
| Beispiel 4 | 220µm 100% M. 3108 550115 | 30µm 100% Compound aus Beispiel 3 |

### Beispiel 5

Bei der OLED handelt es sich um ein 47.5mm x 125mm (Außenabmaße) großen weißemittierenden "Bottom"-Emitter gemäß Ausführungsbeispiel 2b. Die aktive Leuchtfläche beträgt 39.4 cm². Das Bauteil hatte eine anorganische Dünnschichtverkapselung als Diffusionsbarriere. Das Dünnschicht-System tragende Substrat wurde mit einem entsprechenden Deckglas auflaminiert. Die UV-Folie wurde auf einen Teil der Leuchtfläche geklebt (ca. 8 cm²).

Dazu wurde der Liner von einem Haftvermittler (OCA 8212 der Firma 3M) abgezogen und der Haftvermittler an die UV-Schutzfolie angelegt. Die Seite, auf der der Liner abgezogen wurde, zeigte zur zweiten Schicht (B) der UV-Schutzfolie, die Polycarbonat enthielt. Der Haftvermittler wurde mit einer Handwalze auf die UV-Schutzfolie auflaminiert. Eine entsprechend große Probe wurde aus der UV-Schutzfolie zugeschnitten und der Liner auf der von der UV-Schutzfolie abgewandten Seite des Haftvermittlers abgezogen. Der UV-Schutzfolie-Haftvermittler-Verbund wurde mit der freigelegten Haftvermittlerseite zum OLED-Substrat hin ausgerichtet, angelegt und mit einer Handwalze auf die OLED auflaminiert.

Es wurde das Leuchtbild dieser OLED nach 5h Alterungstest unter einer Xenonleuchte (Abstand 0.5 m) untersucht.

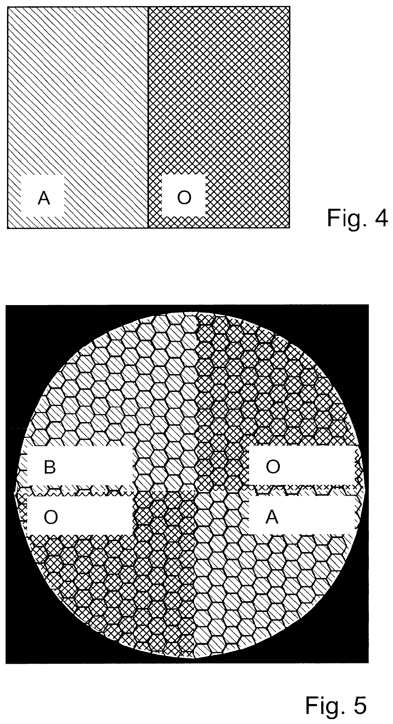

**Figur 4** zeigt das Leuchtbild einer OLED nach 5h Alterungstest unter einer Xenonleuchte (Abstand 0.5 m). Linke Seite versehen mit einer erfindungsgemäßen UV-Schutzfolie nach Beispiel 3 (A) und rechte Seite ohne Folie (O). Die Leuchtdichte der OLED nimmt im ungeschützten Bereich der aktiven Fläche signifikant ab.

**Figur 5** zeigt das Leuchtbild einer OLED nach 5 h Alterungstest unter einer Xenonleuchte (Abstand 0.5 m). Die linke obere Seite (B) ist versehen mit einer UV-Schutzfolie nach Beispiel 4 und die rechte obere Seite (O) trägt keine UV-Schutzfolie. Die rechte untere Seite ist versehen mit einer erfindungsgemäßen UV-Schutzfolie nach Beispiel 3 (A) und die linke untere Seite trägt keine UV-Schutzfolie (O). Die Leuchtdichte der OLED nimmt im ungeschützten Bereich der aktiven Fläche signifikant ab.

Weitere Ausführungsbeispiele sind analog zu irgendeinem der zuvor genannten Ausführungsbeispiele aufgebaut, wobei die UV-Schutzfolie (7) derart relativ zu der aktiven organischen Schicht (2) angeordnet ist, dass deren erste Schicht (A) der aktiven organischen Schicht (2) abgewandt ist und deren zweite Schicht (B) der aktiven organischen Schicht (2) zugewandt ist. Die erste Schicht kann dabei eine sich auf einer der aktiven organischen Schicht (2) abgewandte Seite der ersten Schicht über die gesamte erste Schicht erstreckende Schichtoberfläche aufweisen, die frei von regelmäßig angeordneten geometrischen Strukturelementen ist. Alternativ oder zusätzlich kann die erste Schicht eine sich auf einer der aktiven organischen Schicht abgewandten Seite der ersten Schicht über die gesamte erste Schicht erstreckende Schichtoberfläche aufweisen, die frei ist von Hervorstehungen auf der Schichtoberfläche und/oder Vertiefungen in der Schichtoberfläche mit einer Höhe bzw. Tiefe von mehr als 2 µm, vorzugsweise mehr als 1 µm.

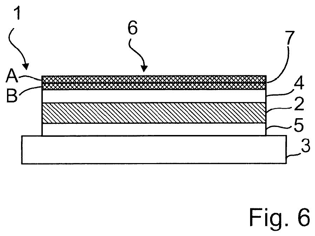

**Figur 6** zeigt diesbezüglich ein weiteres beispielhaftes Ausführungsbeispiel eines erfindungsgemäßen strahlungsemittierenden Bauelements. Dieses ist ähnlich zu dem Ausführungsbeispiel von Figur 1a aufgebaut, und weist alle zuvor hinsichtlich Figur 1 beschriebenen Merkmale auf.

Die UV-Schutzfolie (7) ist bei dem vorliegenden Ausführungsbeispiel derart relativ zu der aktiven organischen Schicht (2) angeordnet ist, dass deren erste Schicht (A) der aktiven organischen Schicht (2) abgewandt ist und deren zweite Schicht (B) der aktiven organischen Schicht (2) zugewandt ist. Die erste Schicht kann eine sich auf einer der aktiven organischen Schicht (2) abgewandte Seite der ersten Schicht über die gesamte erste Schicht erstreckende Schichtoberfläche aufweisen, die frei von regelmäßig angeordneten geometrischen Strukturelementen ist. Vorzugsweise ist eine sich auf einer der aktiven organischen Schicht abgewandten Seite über die gesamte erste Schicht erstreckende Schichtoberfläche der ersten Schicht frei von Hervorstehungen auf der Schichtoberfläche und/oder Vertiefungen in der Schichtoberfläche mit einer Höhe bzw. Tiefe von mehr als 1 µm oder mehr als 2 µm.

Weitere Ausführungsbeispiele sind analog zu irgendeinem der zuvor genannten Ausführungsbeispiele aufgebaut, wobei eine Rauhigkeit von einer der aktiven organischen Schicht (2) abgewandte Oberfläche der ersten Schicht (A) kleiner oder gleich 2 µm ist und/oder ein Glanzgrad für einen Winkel von 60° von einer der aktiven organischen Schicht (2) abgewandten Oberfläche der ersten Schicht größer oder gleich 70 ist und/oder die UV-Schutzfolie frei von Partikeln oder Stoffen mit streuenden Eigenschaften ist und/oder die UV-Schutzfolie frei von Regionen mit streuenden Eigenschaften ist.

## Patentansprüche

1. Organisches strahlungsemittierendes Bauelement (1) mit einer zur Strahlungserzeugung ausgebildeten aktiven organischen Schicht (2) und einer oder zwei Strahlungsauskoppelseiten (6, 602), wobei auf mindestens einer Strahlungsauskoppelseite des Bauelements eine UV-Schutzfolie (7) angeordnet und mit dem Bauelement verbunden ist, wobei die UV-Schutzfolie (7) mindestens eine erste Schicht (A) und eine zweite Schicht (B) enthält, **dadurch gekennzeichnet, dass** die erste Schicht (A) 1 bis 7,5 Gew.-%, bezogen auf das Gesamtgewicht der ersten Schicht (A), eines UV-Absorbers enthält und wobei die zweite Schicht (B) Polycarbonat enthält, und wobei die erste Schicht (A) Polymethacrylat enthält und eine Schichtdicke von ≥ 10 µm und ≤ 200 µm aufweist.

2. Bauelement (1) nach Anspruch 1, **dadurch gekennzeichnet, dass** die UV-Schutzfolie frei von Partikeln oder Stoffen mit streuenden Eigenschaften ist.

3. Bauelement (1) nach einem der vorhergehenden Ansprüche, **dadurch gekennzeichnet, dass** die UV-Schutzfolie derart relativ zu der aktiven organischen Schicht (2) angeordnet ist, dass deren erste Schicht (A) der aktiven organischen Schicht (2) abgewandt ist und deren zweite Schicht (B) der aktiven organischen Schicht (2) zugewandt ist.

4. Bauelement (1) nach Anspruch 3, **dadurch gekennzeichnet, dass** eine Rauhigkeit von einer der aktiven organischen Schicht (2) abgewandte Oberfläche der ersten Schicht (A) kleiner oder gleich 2 µm ist und/oder ein Glanzgrad für einen Winkel von 60° von einer der aktiven organischen Schicht (2) abgewandten Oberfläche der ersten Schicht größer oder gleich 70 ist.

5. Bauelement (1) nach Anspruch 3 oder 4, **dadurch gekennzeichnet, dass** die erste Schicht eine sich auf einer der aktiven organischen Schicht (2) abgewandte Seite der ersten Schicht über die gesamte erste Schicht erstreckende Schichtoberfläche aufweist, die frei von regelmäßig angeordneten geometrischen Strukturelementen ist.

6. Bauelement nach einem der vorhergehenden Ansprüche, **dadurch gekennzeichnet, dass** es sich bei dem UV Absorber um einen organischen UV Absorber handelt.

7. Bauelement nach einem der vorhergehenden Ansprüche, **dadurch gekennzeichnet, dass** es sich bei dem UV Absorber um ein Triazin-Derivat handelt.

8. Bauelement nach einem der vorhergehenden Ansprüche, **dadurch gekennzeichnet, dass** die erste Schicht (A) und die zweite Schicht (B) coextrudiert ausgeführt sind.

9. Bauelement nach einem der vorhergehenden Ansprüche, **dadurch gekennzeichnet, dass** die UV-Schutzfolie (7) eine Dicke von ≥ 90 µm und ≤ 600 µm.

10. Bauelement nach einem der vorhergehenden Ansprüche, **dadurch gekennzeichnet, dass** die erste Schicht (A) der UV-Schutzfolie (7) ein Coating aufweist.

11. Bauelement nach einem der vorhergehenden Ansprüche, **dadurch gekennzeichnet, dass** die UV-Schutzfolie (7) an dem Bauelement (1) mittels eines Haftvermittlers (8) befestigt oder die UV-Schutzfolie auf das Bauelement auflaminiert ist.

12. Verwendung eines Bauelement nach einem der vorhergehenden Ansprüche als organische lichtemittierende Diode und/oder zur Beleuchtung, insbesondere zur Allgemeinbeleuchtung.

## Claims

1. Organic radiation-emitting component (1) having an active organic layer (2) designed to generate radiation and one or two radiation outcoupling faces (6, 602), wherein a UV protection film (7) has been disposed on at least one radiation outcoupling face of the component and is connected to the component, wherein the UV protection film (7) contains at least a first layer (A) and a second layer (B), **characterized in that** the first layer (A) contains 1% to 7.5% by weight, based on the total weight of the first layer (A), of a UV absorber, and wherein the second layer (B) contains polycarbonate, and wherein the first layer (A) contains polymethacrylate and has a layer thickness of ≥ 10 µm and ≥ 200 µm.

2. Component (1) according to Claim 1, **characterized in that** the UV protection film is free of particles or substances having scattering properties.

3. Component (1) according to either of the preceding claims, **characterized in that** the UV protection film is arranged relative to the active organic layer (2) in such a way that the first layer (A) thereof is remote from the active organic layer (2) and the second layer (B) thereof faces the active organic layer (2).

4. Component (1) according to Claim 3, **characterized in that** a roughness of a surface of the first layer (A) remote from the active organic layer (2) is not more than 2 µm and/or a gloss for an angle of 60° of a surface of the first layer remote from the active organic layer (2) is not less than 70.

5. Component (1) according to Claim 3 or 4, **characterized in that** the first layer has a layer surface that extends over the entire first layer on a side of the first layer remote from the active organic layer (2) and is free of geometric structural elements in a regular arrangement.

6. Component according to any of the preceding claims, **characterized in that** the UV absorber is an organic UV absorber.

7. Component according to any of the preceding claims, **characterized in that** the UV absorber is a triazine derivative.

8. Component according to any of the preceding claims, **characterized in that** the first layer (A) and the second layer (B) are in coextruded form.

9. Component according to any of the preceding claims, **characterized in that** the UV protection film (7) has a thickness of ≥ 90 µm and ≤ 600 µm.

10. Component according to any of the preceding claims, **characterized in that** the first layer (A) of the UV protection film (7) has a coating.

11. Component according to any of the preceding claims, **characterized in that** the UV protection film (7) on the component (1) has been secured by means of an adhesion promoter (8) or the UV protection film has been laminated onto the component.

12. Use of a component according to any of the preceding claims as organic light-emitting diode and/or for lighting, especially for general lighting.

## Revendications

1. Composant organique émettant un rayonnement (1) comprenant une couche organique active configurée pour la génération d'un rayonnement (2) et un ou deux côtés de découplage de rayonnement (6, 602), un film de protection UV (7) étant agencé sur au moins un côté de découplage de rayonnement du composant et relié avec le composant, le film de protection UV (7) contenant au moins une première couche (A) et une deuxième couche (B), **caractérisé en ce que** la première couche (A) contient 1 à 7,5 % en poids, par rapport au poids total de la première couche (A), d'un absorbeur UV, et la deuxième couche (B) contient un polycarbonate, et la première couche (A) contient un polyméthacrylate et présente une épaisseur de couche de ≥ 10 µm et ≤ 200 µm.

2. Composant (1) selon la revendication 1, **caractérisé en ce que** le film de protection UV est exempt de particules ou de matières ayant des propriétés de dispersion.

3. Composant (1) selon l'une quelconque des revendications précédentes, **caractérisé en ce que** le film de protection UV est agencé par rapport à la couche organique active (2) de telle sorte que sa première couche (A) soit détournée de la couche organique active (2) et sa deuxième couche (B) soit tournée vers la couche organique active (2).

4. Composant (1) selon la revendication 3, **caractérisé en ce qu'**une rugosité d'une surface de la première couche (A) détournée de la couche organique active (2) est inférieure ou égale à 2 µm et/ou un degré de brillance pour un angle de 60° d'une surface de la première couche détournée de la couche organique active (2) est supérieur ou égal à 70.

5. Composant (1) selon la revendication 3 ou 4, **caractérisé en ce que** la première couche comprend une surface de couche qui s'étend sur l'ensemble de la première couche sur un côté de la première couche détourné de la couche organique active (2), qui est exempte d'éléments structuraux géométriques agencés régulièrement.

6. Composant selon l'une quelconque des revendications précédentes, **caractérisé en ce que** l'absorbeur UV consiste en un absorbeur UV organique.

7. Composant selon l'une quelconque des revendications précédentes, **caractérisé en ce que** l'absorbeur UV consiste en un dérivé de triazine.

8. Composant selon l'une quelconque des revendications précédentes, **caractérisé en ce que** la première couche (A) et la deuxième couche (B) sont coextrudées.

9. Composant selon l'une quelconque des revendications précédentes, **caractérisé en ce que** le film de protection UV (7) présente une épaisseur de ≥ 90 µm et ≤ 600 µm.

10. Composant selon l'une quelconque des revendications précédentes, **caractérisé en ce que** la première couche (A) du film de protection UV (7) comprend un revêtement.

11. Composant selon l'une quelconque des revendications précédentes, **caractérisé en ce que** le film de protection UV (7) est fixé sur le composant (1) au moyen d'un promoteur d'adhésion (8) ou le film de protection UV est stratifié sur le composant.

12. Utilisation d'un composant selon l'une quelconque des revendications précédentes en tant que diode organique électroluminescente et/ou pour l'éclairage, notamment l'éclairage général.
